# EUROPEAN PATENT APPLICATION

(11) **EP 4 687 300 A1**
(43) Date of publication of application: **04.02.2026**
(21) Application number: 25160323.9
(22) Date of filing: 26.02.2025
(51) Int. Cl.: H03M 13/11, H03M 13/37, G06F 11/00

(54) **BIT-FLIPPING DECODER WITH ADAPTIVE FLIPPING THRESHOLD**

(30) Priority: 29.07.2024 CN 202411030771
(71) Applicant: Yangtze Memory Technologies Co., Ltd., Wuhan, Hubei 430000 (CN)
(72) Inventor: ZHUANG, Zhiwei, Wuhan, Hubei, 430000 (CN); WANG, Dili, Wuhan, Hubei, 430000 (CN)
(74) Representative: Lippert Stachow Patentanwälte Rechtsanwälte

(57) **Abstract**

According to one aspect of the present disclosure, a decoder is provided. The decoder may include a first processing circuit to: obtain a check formula and check formula weight based on a codeword to be decoded in a current iteration and a check matrix; a second processing circuit to: obtain energy of the codeword to be decoded based on the check formula, the check matrix and a flipping state of the codeword to be decoded; a processor to: in a first iteration, select a preset threshold sequence as an initial threshold sequence based on the check formula weight; and assign a flipping threshold in the initial threshold sequence to a bit flipping circuit; and the bit flipping circuit to: output a codeword to be decoded in a following iteration based on a result of a comparison between energy of the codeword to be decoded and the flipping threshold.

## Description

### CROSS-REFERENCE TO RELATED APPLICATIONS

The present application claims the benefit of priority to Chinese Application No. 202411030771.5, filed on July 29, 2024, which is hereby incorporated by reference in its entirety.

### TECHNICAL FIELD

The present disclosure relates to the field of semiconductor technology, and in particular to a decoder, a decoding method, a memory system and a controller.

### BACKGROUND

A memory device is a storage apparatus used to save information in modern information technologies. As a typical nonvolatile semiconductor memory, a Not-And (NAND) type memory gradually becomes a mainstream product in the memory market due to a relatively high memory density, controllable production costs, and appropriate program and erase speed. However, with the increasingly high requirements for the storage apparatus, there is still much room for improvements in the memory device and a system thereof.

### SUMMARY

According to one aspect of the present disclosure, a decoder is provided. The decoder may include a first processing circuit configured to obtain a check formula and check formula weight based on a codeword to be decoded in a current iteration and a check matrix. The decoder may include a second processing circuit configured to obtain energy of the codeword to be decoded in the current iteration based on the check formula, the check matrix and a flipping state of the codeword to be decoded in the current iteration. The decoder may include a processor. The processor may be configured to, in a first iteration, select one of a plurality of preset threshold sequences as an initial threshold sequence based on the check formula weight. The processor may be configured to assign a flipping threshold in the initial threshold sequence to a bit flipping circuit. The decoder may include the bit flipping circuit. The bit flipping circuit may be configured to output the codeword to be decoded in a following iteration based on a result of a comparison between the energy of the codeword to be decoded in the current iteration and the flipping threshold assigned by the processor.

In some implementations, the processor may be configured to, in the first iteration, obtain N+1 preset threshold sequences, compare the check formula weight with N first thresholds, and select one of the N+1 preset threshold sequences as the initial threshold sequence according to a result of the comparison. In some implementations, the initial threshold sequence may include M flipping thresholds, N may be a positive integer, and M may be an integer greater than 1. In some implementations, the processor may be configured to, in a Lth iteration, assign a Lth flipping threshold in the initial threshold sequence to the bit flipping circuit. In some implementations, L may be a positive integer less than or equal to M.

In some implementations, N may be 1. In some implementations, the processor may be configured to, in the first iteration, compare the check formula weight with one of the first thresholds. In some implementations, the processor may be configured to, according to the check formula weight being greater than the first threshold, select a preset threshold sequence corresponding to the check formula weight being greater than the first threshold as the initial threshold sequence, or, according to the check formula weight being less than or equal to the first threshold, select a preset threshold sequence corresponding to the check formula weight being less than or equal to the first threshold as the initial threshold sequence.

In some implementations, N may be greater than 1. In some implementations, the processor may be configured to, in the first iteration, compare the check formula weight with a plurality of the first thresholds to determine a threshold interval in which the check formula weight is located. In some implementations, the processor may be configured to select a preset threshold sequence corresponding to the threshold interval in which the check formula weight is located as the initial threshold sequence.

In some implementations, the processor may be further configured to, in an M+Xth iteration, obtain a cyclic threshold sequence, and assign a flipping threshold in the cyclic threshold sequence to the bit flipping circuit. In some implementations, X may be a positive integer.

In some implementations, the processor may be further configured to, in an M+1th iteration, obtain P+1 preset cyclic sequences, compare the check formula weight in the first iteration or the check formula weight in the M+1th iteration with P second thresholds, and select one of the P+1 preset cyclic sequences as the cyclic threshold sequence according to a result of the comparison. In some implementations, P may be a positive integer.

In some implementations, the second processing circuit may be configured to perform a first calculation on the check formula and the check matrix to obtain a number of errors corresponding to each bit in the codeword to be decoded in the current iteration. In some implementations, the second processing circuit may be configured to, according to a flipping state of each bit in the codeword to be decoded in the current iteration, obtain a label value corresponding to each bit. In some implementations, the second processing circuit may be configured to perform a second calculation on the number of errors and the label value corresponding to each bit in the codeword to be decoded in the current iteration, to obtain the energy of the codeword to be decoded.

In some implementations, the bit flipping circuit may be configured to compare energy of each bit in the codeword to be decoded in the current iteration with the flipping threshold. In some implementations, the bit flipping circuit may be configured to flip a bit according to the energy of the bit being greater than the flipping threshold, or keep a bit unchanged according to the energy of the bit being less than or equal to the flipping threshold, to obtain a decoded codeword in the current iteration. In some implementations, the bit flipping circuit may be configured to output the decoded codeword in the current iteration as the codeword to be decoded in the following iteration.

In some implementations, the first processing circuit may be configured to perform a third calculation on the codeword to be decoded in the current iteration and the check matrix, to obtain the check formula. In some implementations, the first processing circuit may be configured to count a number of bits being 1 in the check formula to obtain the check formula weight.

In some implementations, the decoder may include an output circuit configured to output the codeword to be decoded in the current iteration as a final decoded codeword according to bits in the check formula in the current iteration all being 0.

According to another aspect of the present disclosure, a method of decoding is provided. The method may include obtaining a check formula and check formula weight based on a codeword to be decoded in a current iteration and a check matrix. The method may include obtaining energy of the codeword to be decoded in the current iteration based on the check formula, the check matrix and a flipping state of the codeword to be decoded in the current iteration. The method may include, in a first iteration, selecting one of a plurality of preset threshold sequences as an initial threshold sequence based on the check formula weight. The method may include outputting a codeword to be decoded in a following iteration based on a result of a comparison between the energy of the codeword to be decoded in the current iteration and a flipping threshold in the initial threshold sequence.

In some implementations, in a first iteration, selecting one of a plurality of preset threshold sequences as an initial threshold sequence based on the check formula weight, and outputting a codeword to be decoded in a following iteration based on a result of a comparison between the energy of the codeword to be decoded in the current iteration and a flipping threshold in the initial threshold sequence may include, in the first iteration, obtaining N+1 preset threshold sequences, comparing the check formula weight with N first thresholds, and selecting one of the N+1 preset threshold sequences as the initial threshold sequence according to a result of the comparison. In some implementations, the initial threshold sequence may include M flipping thresholds. In some implementations, N may be a positive integer. In some implementations, M may be an integer greater than 1. In some implementations, in a first iteration, selecting one of a plurality of preset threshold sequences as an initial threshold sequence based on the check formula weight, and outputting a codeword to be decoded in a following iteration based on a result of a comparison between the energy of the codeword to be decoded in the current iteration and a flipping threshold in the initial threshold sequence may include, in a Lth iteration, outputting the codeword to be decoded in the following iteration based on a result of a comparison between the energy of the codeword to be decoded in the current iteration and a Lth flipping threshold in the initial threshold sequence. In some implementations, L may be a positive integer less than or equal to M.

In some implementations, N may be 1. In some implementations, in the first iteration, comparing the check formula weight with N first thresholds, and selecting one of the N+1 preset threshold sequences as the initial threshold sequence according to a result of the comparison may include in the first iteration, comparing the check formula weight with one of the first thresholds. In some implementations, in the first iteration, comparing the check formula weight with N first thresholds, and selecting one of the N+1 preset threshold sequences as the initial threshold sequence according to a result of the comparison may include, according to the check formula weight being greater than the first threshold, selecting a preset threshold sequence corresponding to the check formula weight being greater than the first threshold as the initial threshold sequence, or, according to the check formula weight being less than or equal to the first threshold, selecting a preset threshold sequence corresponding to the check formula weight being less than or equal to the first threshold as the initial threshold sequence.

In some implementations, N may be 1. In some implementations, in the first iteration, comparing the check formula weight with N first thresholds, and selecting one of the N+1 preset threshold sequences as the initial threshold sequence according to a result of the comparison may include, in the first iteration, comparing the check formula weight with a plurality of the first thresholds to determine a threshold interval in which the check formula weight is located. In some implementations, in the first iteration, comparing the check formula weight with N first thresholds, and selecting one of the N+1 preset threshold sequences as the initial threshold sequence according to a result of the comparison may include selecting a preset threshold sequence corresponding to the threshold interval in which the check formula weight is located as the initial threshold sequence.

In some implementations, the method may include, in an M+Xth iteration, obtaining a cyclic threshold sequence, and outputting the codeword to be decoded in the following iteration based on a result of a comparison between the energy of the codeword to be decoded in the current iteration and a flipping threshold in the cyclic threshold sequence. In some implementation, X may be a positive integer.

In some implementations, the method may include, in an M+1th iteration, obtaining P+1 preset cyclic sequences, comparing the check formula weight in the first iteration or the check formula weight in the M+1th iteration with P second thresholds, and selecting one of the P+1 preset cyclic sequences as the cyclic threshold sequence according to a result of the comparison. In some implementations, P may be a positive integer.

In some implementations, obtaining energy of the codeword to be decoded in the current iteration based on the check formula, the check matrix and a flipping state of the codeword to be decoded in the current iteration may include performing a first calculation on the check formula and the check matrix to obtain a number of errors corresponding to each bit in the codeword to be decoded in the current iteration. In some implementations, obtaining energy of the codeword to be decoded in the current iteration based on the check formula, the check matrix and a flipping state of the codeword to be decoded in the current iteration may include according to a flipping state of each bit in the codeword to be decoded in the current iteration, obtaining a label value corresponding to each bit. In some implementations, obtaining energy of the codeword to be decoded in the current iteration based on the check formula, the check matrix and a flipping state of the codeword to be decoded in the current iteration may include performing a second calculation on the number of errors and the label value corresponding to each bit in the codeword to be decoded in the current iteration, to obtain the energy of the codeword to be decoded.

In some implementations, outputting a codeword to be decoded in a following iteration based on a result of a comparison between the energy of the codeword to be decoded in the current iteration and a flipping threshold in the initial threshold sequence may include comparing energy of each bit in the codeword to be decoded in the current iteration with the flipping threshold. In some implementations, outputting a codeword to be decoded in a following iteration based on a result of a comparison between the energy of the codeword to be decoded in the current iteration and a flipping threshold in the initial threshold sequence may include flipping a bit according to the energy of the bit being greater than the flipping threshold, or keeping a bit unchanged according to the energy of the bit being less than or equal to the flipping threshold, to obtain a decoded codeword in the current iteration. In some implementations, outputting a codeword to be decoded in a following iteration based on a result of a comparison between the energy of the codeword to be decoded in the current iteration and a flipping threshold in the initial threshold sequence may include outputting the decoded codeword in the current iteration as the codeword to be decoded in the following iteration.

In some implementations, obtaining a check formula and check formula weight based on a codeword to be decoded in a current iteration and a check matrix may include performing a third calculation on the codeword to be decoded in the current iteration and the check matrix to obtain the check formula. In some implementations, obtaining a check formula and check formula weight based on a codeword to be decoded in a current iteration and a check matrix may include counting a number of bits being 1 in the check formula to obtain the check formula weight.

In some implementations, the method may include outputting the codeword to be decoded in the current iteration as a final decoded codeword according to bits in the check formula in the current iteration all being 0.

According to a further aspect of the disclosure, a memory system is provided. The memory system may include a memory configured to output read data. The memory system may include a decoder configured to decode a codeword to be decoded in the read data. The decoder may include a first processing circuit configured to obtain a check formula and check formula weight based on a codeword to be decoded in a current iteration and a check matrix. The decoder may include a first processing circuit configured to a second processing circuit configured to obtain energy of the codeword to be decoded in the current iteration based on the check formula, the check matrix and a flipping state of the codeword to be decoded in the current iteration. The decoder may include a processor configured to, in a first iteration, select one of a plurality of preset threshold sequences as an initial threshold sequence based on the check formula weight. The decoder may include a processor configured to assign a flipping threshold in the initial threshold sequence to a bit flipping circuit. The decoder may include the bit flipping circuit. The bit flipping circuit may be configured to output a codeword to be decoded in a following iteration based on a result of a comparison between the energy of the codeword to be decoded in the current iteration and the flipping threshold assigned by the processor.

In some implementations, the memory system may include an encoder configured to receive write data and encode the write data. In some implementations, the memory may be further configured to receive encoded write data.

In some implementations, the memory system may include a controller coupled with the memory. In some implementations, the controller may include the decoder and the encoder.

According to yet another aspect of the present disclosure, a controller is provided. The controller may include an interface configured to receive read data. The controller may include a decoder configured to decode a codeword to be decoded in the read data. The decoder may include a first processing circuit configured to obtain a check formula and check formula weight based on a codeword to be decoded in a current iteration and a check matrix. The decoder may include a second processing circuit configured to obtain energy of the codeword to be decoded in the current iteration based on the check formula, the check matrix and a flipping state of the codeword to be decoded in the current iteration. The decoder may include a processor configured to, in a first iteration, select one of a plurality of preset threshold sequences as an initial threshold sequence based on the check formula weight. The processor may be configured to assign a flipping threshold in the initial threshold sequence to a bit flipping circuit. The decoder may include the bit flipping circuit. The bit flipping circuit may be configured to output a codeword to be decoded in a following iteration based on a result of a comparison between the energy of the codeword to be decoded in the current iteration and the flipping threshold assigned by the processor.

In the technical solution provided by the present disclosure, the processor can obtain a plurality of preset threshold sequences which are preset, select one of the plurality of preset threshold sequences as the initial threshold sequence based on the relationship between the initial check formula weight and the first threshold, and in each iteration, assign a flipping threshold in the initial threshold sequence to the bit flipping circuit, so that the bit flipping circuit determines whether to perform bit flipping on the codeword to be decoded in the current iteration based on the relationship between the flipping threshold and the check formula weight. On the one hand, selecting the initial threshold sequence based on the initial check formula weight can provide different flipping thresholds for codewords to be decoded with different degrees of error, which can improve the flexibility and pertinence of the selection of the flipping threshold, thereby improving the decoding performance of the decoder. On the other hand, the initial threshold sequence may include a plurality of flipping thresholds, which can avoid the prolongation of the decoding time caused by the need to determine the corresponding flipping threshold by a complex algorithm in each iteration, and thus can improve the decoding efficiency of the decoder.

### BRIEF DESCRIPTION OF THE DRAWINGS

FIG. 1 is a schematic diagram 1 of an example system with a memory system, according to an example of the present disclosure.
FIG. 2 is a schematic diagram of an example memory card with a memory system, according to an example of the present disclosure.
FIG. 3 is a schematic diagram of an example solid-state drive with a memory system, according to an example of the present disclosure.
FIG. 4 is a schematic diagram of an example memory device including a peripheral circuit, according to an example of the present disclosure.
FIG. 5 is a schematic diagram of an example memory including a memory array and a peripheral circuit, according to an example of the present disclosure.
FIG. 6 is a schematic diagram 2 of an example system with a memory system, according to an example of the present disclosure.
FIG. 7 is a structural schematic diagram 1 of a decoder, according to an example of the present disclosure.
FIG. 8 is a flowchart of a decoding process, according to an example of the present disclosure.
FIG. 9 is a structural schematic diagram 2 of a decoder, according to an example of the present disclosure.
FIG. 10 is a structural schematic diagram of a first processing circuit, according to an example of the present disclosure.
FIG. 11 is a structural schematic diagram of a second processing circuit, according to an example of the present disclosure.
FIG. 12 is a structural schematic diagram of a bit flipping circuit, according to an example of the present disclosure.
FIG. 13 is a circuit structural schematic diagram 1 of a processor, according to an example of the present disclosure.
FIG. 14 is a circuit structural schematic diagram 2 of a processor, according to an example of the present disclosure.
FIG. 15 is a flowchart of a decoding method, according to an example of the present disclosure.

### DETAILED DESCRIPTION

Examples of the present disclosure will be described in more detail below with reference to the accompanying drawings. Although examples of the present disclosure are shown in the drawings, it should be understood that the present disclosure may be implemented in various ways and should not be limited to the DETAILED DESCRIPTION set forth herein. Rather, these examples are provided so that the present disclosure can be more thoroughly understood and the scope of the present disclosure can be fully conveyed to those skilled in the art.

In the following description, numerous specific details are given in order to provide a more thorough understanding of the present disclosure. It will be apparent, however, to one skilled in the art that the present disclosure may be practiced without one or more of these details. In other examples, some technical features well-known in the art are not described to avoid confusion with the present disclosure; that is, not all features of the actual example are described here, and well-known functions and structures are not described in detail.

In the accompanying drawings, the same reference numerals represent the same elements throughout.

It should be understood that spatial relationship terms such as "under", "below", "beneath", "underneath", "on", "above" and so on, can be used here for convenience to describe the relationship between one element or feature and other elements or features shown in the figures. It will be understood that the spatially relationship terms also comprise different orientations of the device in use and operation in addition to the orientation depicted in the figures. For example, if the device in the figures is turned over, elements or features described as "below" or "underneath" or "under" other elements or features would then be oriented as "above" the other elements or features. Thus, the example terms "below" and "under" can comprise both orientations of above and below. The device may be otherwise oriented (rotated 90 degrees or at other orientations) and the spatial description terms used herein may be interpreted accordingly.

The terminology used herein is for the purpose of describing particular examples only and is not to be taken as a limitation of the present disclosure. As used herein, "a", "an" and "said/the" in singular forms are intended to include the plural forms as well, unless the context clearly dictates otherwise. It should also be understood that at least one of the terms "consist of" or "comprise", when used in this specification, identify the presence of at least one of stated features, integers, operations, elements or components, but do not exclude presence or addition of at least one of one or more other features, integers, operations, elements, components or groups. As used herein, the term "at least one of ..." includes any and all combinations of the associated listed items.

In order to improve the reliability of data transmission and data storage, error correcting code (ECC) technology has been widely used in the field of digital communication, such as wireless communication and fiber-optic communication, and the field of data storage, such as memory systems. Among various error correcting codes, Low Density Parity Check (LDPC) code is a parallel iterative coding algorithm based on sparse matrices. LDPC has the performance of approaching Shannon's limit. The decoding of LDPC is simple and can be implemented in parallel operation, which has become one of the most widely used error correcting codes.

As a typical non-volatile semiconductor memory, a Not-And (NAND) type memory gradually becomes a mainstream product in the memory market due to a relatively high memory density, controllable production costs, and appropriate program and erase speed. During the transmission and storage of data in the NAND type memory, data errors may occur due to hardware failure, software failure, hard disk error, etc. of the memory. In order to ensure the integrity of user data, it has been proposed to use LDPC code to detect and correct errors in data stored in a memory system including the NAND type memory. Below, the memory system provided by the present disclosure will be described by taking a memory system including a three-dimensional NAND type memory as an example.

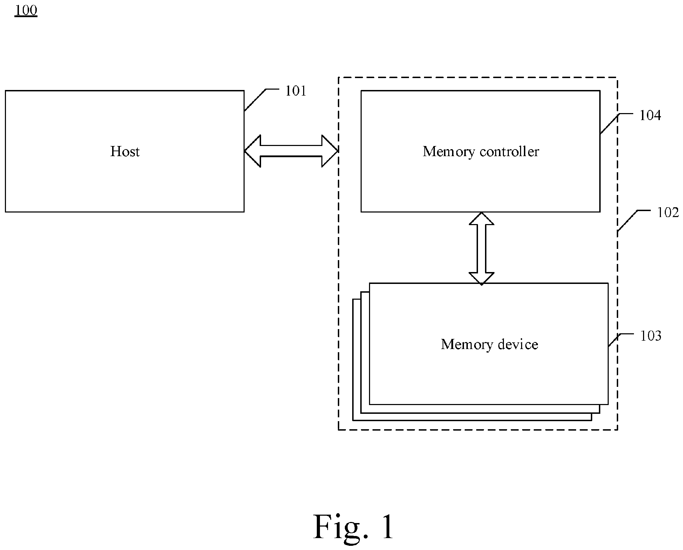

FIG. 1 is a schematic diagram of an example system with a memory system provided in an example of the present disclosure. In an example of the present disclosure, the system 100 may include a mobile phone, a desktop computer, a laptop, a tablet, a vehicle computer, a game console, a printer, a positioning device, a wearable electronic device, a smart sensor, a virtual reality (VR) device, an augmented reality (AR) device, or any other suitable electronic device having a memory therein. As shown in FIG. 1, the system 100 may include a host 101 and a memory system 102, where the memory system 102 may include one or more memory devices 103 and a memory controller 104. The host 101 may include a processor of an electronic device, such as a central processing unit (CPU), or a system on a chip (SoC), such as an application processor (AP). The host 101 may be configured to send data to the memory system 102 or receive data from the memory system 102.

In some examples, the memory controller 104 is coupled to the memory device 103 and the host 101, and is configured to control the memory device 103. The memory controller 104 can manage data stored in the memory device 103 and communicate with the host 101. In some examples, the memory controller 104 is designed to operate in a low duty cycle environment, such as in a secure digital card, a compact flash card (CFC), a universal serial bus (USB) flash drive, or in other media used in electronic devices such as personal computers, digital cameras, mobile phones, etc. In other examples, the memory controller 104 is designed to operate in a high duty cycle environment, such as a solid state drive or an embedded multimedia card (eMMC).

In some examples, the memory controller 104 and one or more memory devices 103 can be integrated into various types of storage devices, that is, the memory system 102 can be implemented and packaged into different types of end electronic products.

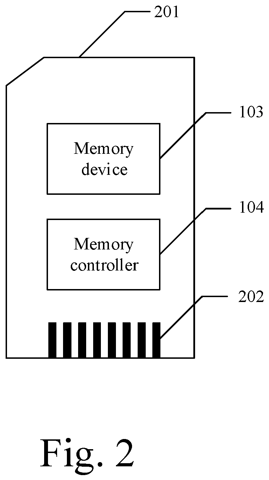

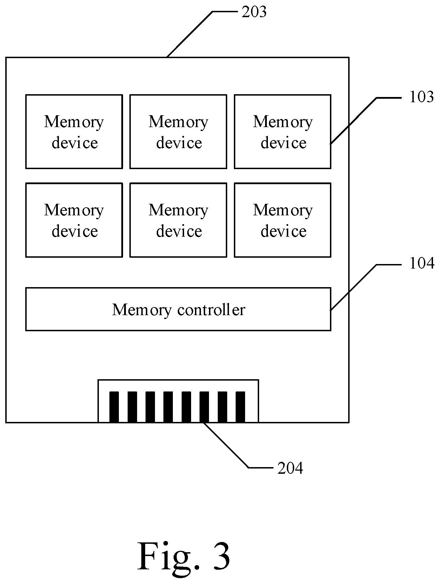

In an example as shown in FIG. 2, the memory controller 104 and a single memory device 103 can be integrated into a memory card 201. The memory card 201 may include a compact flash card, a smart media card (SMC), a memory stick (MS), a multimedia card (MMC), such as RS-MMC, MMCmicro, eMMC, etc., a secure digital card, such as a Mini SD card, a Micro SD card, an SDHC card, etc., or a general flash card. The memory card 201 may also include a memory card connector 202 that couples the memory card 201 with a host-side device (e.g., the host 101 in FIG. 1). In another example as shown in FIG. 3, the memory controller 104 and a plurality of memory devices 103 may be integrated into an SSD 203. The SSD 203 may also include an SSD connector 204 that couples the SSD 203 with a host-side device (e.g., the host 101 in FIG. 1). In some examples, at least one of the storage capacity or operating speed of the SSD 203 is greater than that of the memory card 201.

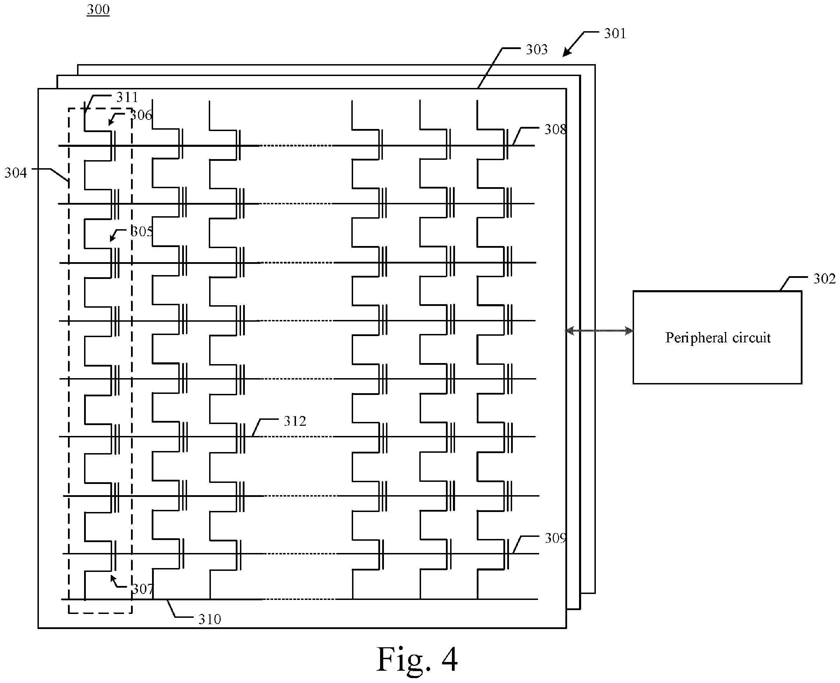

FIG. 4 is a circuit diagram of an example memory device 300 including a peripheral circuit as provided in an example of the present disclosure. The memory device 300 may be an example of the memory device 103 in FIG. 1. The memory device 300 may include a memory array 301 and a peripheral circuit 302 coupled to the memory array 301. The memory array 301 is taken as an example of a three-dimensional NAND type memory array for illustration, where the memory cell 305 is a NAND memory cell, and the memory cell 305 is provided in the form of an array of memory cell strings 304, where each memory cell string 304 extends vertically above a substrate (not shown). In some examples, each memory cell string 304 includes a plurality of memory cells 305 coupled in series and stacked vertically. Each memory cell 305 may hold a continuous analog value, such as a voltage or charge, which depends on the number of electrons trapped in the region of the memory cell 305. Each memory cell 305 may be a floating gate type memory cell including a floating gate transistor, or a charge trap type memory cell including a charge trap transistor.

In some examples, each memory cell 305 is a single level cell (SLC) having two possible memory states and thus can store one bit of data. For example, the first memory state "0" can correspond to a first voltage range, and the second memory state "1" can correspond to a second voltage range. In some examples, each memory cell 305 is a multi-level cell capable of storing more than a single bit of data in four or more memory states, for example, a multi-level cell (MLC) storing two bits per cell, a triple level cell (TLC) storing three bits per cell, or a quad-level cell (QLC) storing four bits per cell.

As shown in FIG. 4, each memory cell string 304 can include a bottom select transistor (BST) 307 at its source end and a top select transistor (TST) 306 at its drain end. The bottom select transistor 307 and the top select transistor 306 can be configured to activate selected memory cell strings 304 during read and program operations. In some examples, the sources of the memory cell strings 304 in the same memory block 303 may be coupled via a common source line (Common Source Line, CSL) 310. In other words, all memory cell strings 304 in the same memory block 303 have an array common source (ACS). According to some examples, the top select transistor 306 of each memory cell string 304 is coupled to a corresponding bit line (BL) 311, and data can be read from or written to the bit line 311 via an output bus (not shown). In some examples, each memory cell string 304 is configured to be selected or deselected by at least one of applying a select voltage (e.g., a voltage higher than a threshold voltage of the top select transistor 306) or a deselect voltage (e.g., 0V) to a top select gate (TSG) of the corresponding top select transistor 306 through one or more top select lines (TSL) 308 or applying a select voltage (e.g., a voltage higher than a threshold voltage of the bottom select transistor 307) or a deselect voltage (e.g., 0V) to a bottom select gate (BSG) of the corresponding bottom select transistor 307 through one or more bottom select lines (BSL) 309.

As shown in FIG. 4, the memory cell strings 304 can be organized into a plurality of memory blocks 303, each of which can have a common source line 310. In some examples, each memory block 303 is a basic data unit for an erase operation, i.e., all memory cells 305 on the same memory block 303 are erased at the same time. To erase the memory cells 305 in the selected memory block, a common source line 310 coupled to the selected memory block and unselected memory blocks in the same plane as the selected memory block may be biased with an erase voltage. It should be understood that in some examples, the erase operation may be performed at a half-memory block level, at a quarter-memory block level, or at a level having any suitable number of memory blocks or any suitable fractions of a memory block. The memory cells 305 of adjacent memory cell strings 304 may be coupled via word lines 312, which select which row of memory cells 305 is affected by read or program operations.

In some examples, the peripheral circuit 302 may include any suitable analog, digital, and mixed-signal circuits for enabling the operations of the memory array 301 by applying and sensing at least one of voltage signals or current signals to and from each target memory cell 305 through bit lines 311, word lines 312, common source lines 310, bottom select lines 309, and top select lines 308 to implement operation of the memory array 301. The peripheral circuit 302 may include various types of peripheral circuits formed using metal-oxide-semiconductor technology.

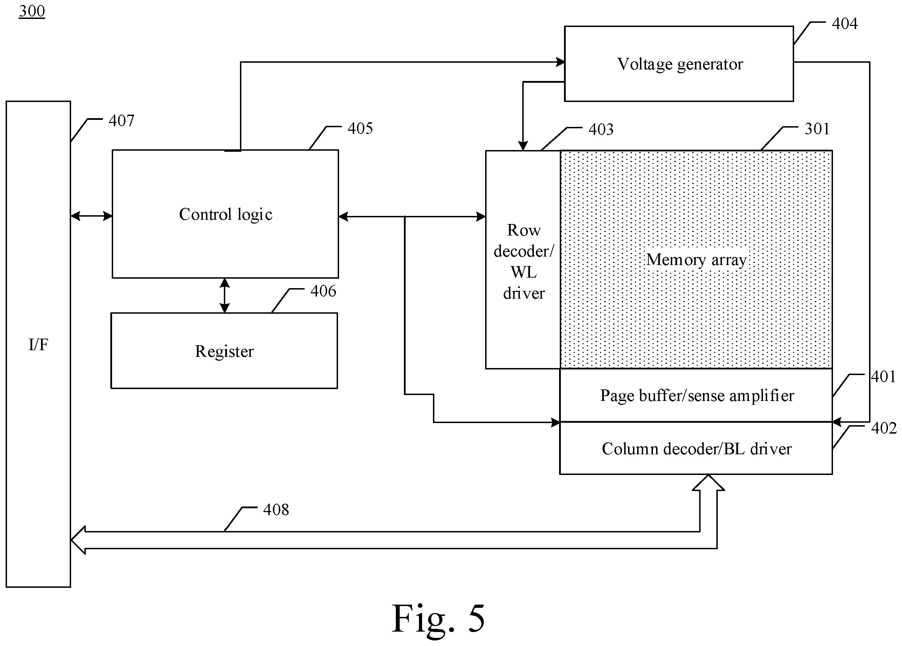

FIG. 5 shows some example peripheral circuits, and the peripheral circuit 302 includes a page buffer/sense amplifier 401, a column decoder/bit line driver 402, a row decoder/word line driver 403, a voltage generator 404, a control logic 405, a register group 406, a flash memory interface 407, and a data bus 408. It should be understood that in some examples, additional peripheral circuits not shown in FIG. 5 may also be included.

The page buffer/sense amplifier 401 can be configured to read data from the memory array 301 and program (write) data to the memory array 301 according to a control signal from the control logic 405. In one example, the page buffer/sense amplifier 401 can store a page of program data (write data) to be programmed into the memory array 301. In another example, the page buffer/sense amplifier 401 can perform a program verify operation to ensure that the data has been correctly programmed into the memory cells coupled to the selected word line. In yet another example, the page buffer/sense amplifier 401 can also sense the low power signals from the bit line that represent data bits stored in the memory cells and amplify the small voltage swing to recognizable logic levels in a read operation. The column decoder/bit line driver 402 can be configured to be controlled by the control logic 405 and select one or more memory cell strings 304 by applying bit line voltages generated from the voltage generator 404.

The row decoder/word line driver 403 can be configured to be controlled by the control logic 405 and select/deselect memory blocks of the memory array 301 and select/deselect word lines of memory blocks. The row decoder/word line driver 403 can be further configured to drive word lines using word line voltages generated from the voltage generator 404. In some examples, the row decoder/word line driver 403 can also select/deselect and drive bottom select lines and top select lines as well. As described below in detail, the row decoder/word line driver 403 is configured to perform program operations on the memory cells coupled to the selected word line(s). The voltage generator 404 can be configured to be controlled by the control logic 405 and generate the word line voltages (e.g., read voltages, program voltages, pass voltages, local voltages, verification voltages, etc.), bit line voltages, and source line voltages to be supplied to the memory array 301.

The control logic 405 may be coupled to each peripheral circuit described above and configured to control the operation of each peripheral circuit. The register group 406 can be coupled to the control logic 405 and include status registers, command registers, and address registers for storing status information, command operation codes (OP codes), and command addresses for controlling the operations of each peripheral circuit. The flash memory interface 407 may be coupled to the control logic 405 and act as a control buffer to buffer and relay control commands received from a host-side device (not shown) to the control logic 405, and to buffer and relay status information received from the control logic 405 to the memory controller. The flash memory interface 407 may further be coupled to the column decoder/bit line driver 402 via the data bus 408 and act as a data I/O interface and data buffer to buffer and relay data to or from the memory array 301.

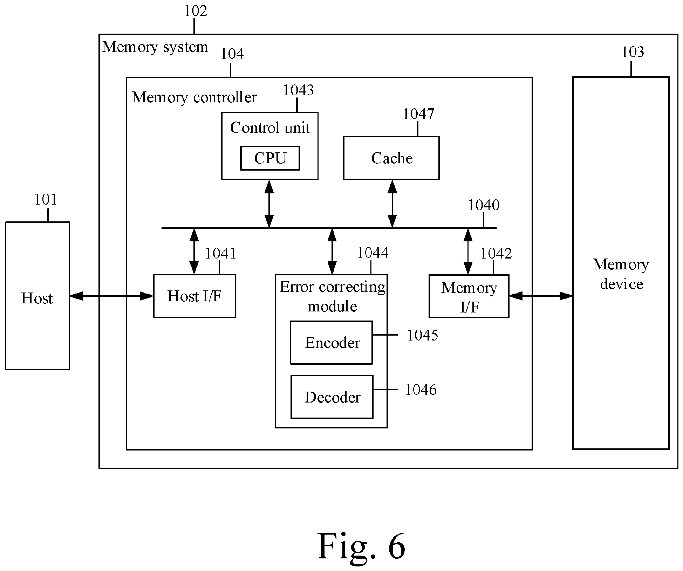

FIG. 6 is a schematic diagram of a system including a host and a memory system provided by an example of the present disclosure. As shown in FIG. 6, a memory system 102 is connected to a host 101, where the memory system 102 may include: a memory controller 104 and a memory device 103, where the memory controller 104 is configured to control the memory device 103 to perform operations such as read, write, and erase, and the memory controller 104 and the memory device 103 may also be coupled in any suitable manner. The memory controller 104 may include a host interface (I/F) 1041, a memory interface (I/F) 1042, a control unit 1043, an error correcting module 1044, a cache 1047, and a bus 1040. Among them, the host interface 1041 is a connection interface between the host 101 and the memory controller 104, and the host interface 1041 allows the host 101 and the memory controller 104 to communicate according to a protocol, send read and write requests, and perform other operations. The memory interface 1042 is a connection interface between the memory controller 104 and the memory device 103, and the memory interface 1042 is configured to enable data transmission between the memory controller 104 and the memory device 103. The control unit 1043 is configured to control the memory system 102 as a whole.

In some examples, the control unit 1043 may include one or more units with logical operation capabilities, such as at least one of a central processing unit (CPU) or a microcontroller unit (MCU).

In some examples, the cache 1047 is configured to cache data, and may be a volatile memory device with a relatively fast read and write speed, such as at least one of a static random access memory (SRAM) or a dynamic random access memory (DRAM).

In some examples, the error correcting module 1044 may be configured to encode and decode data in the memory system 102 using error correcting code technology. In some examples, the error correcting module 1044 may include an encoder 1045 and a decoder 1046, where the encoder 1045 may be configured to: encode data to be written into the memory device in a write operation, and the decoder 1046 may be configured to: decode a codeword to be decoded in read data in a read operation.

In some examples, in the process of decoding the codeword to be decoded in the read data using the decoder 1046, a flipping threshold for determining whether it is needed to flip bits in the codeword to be decoded will monotonically decrease to a fixed value as the number of decoding iterations increases, and the decoding performance of the decoder 1046 needs to be improved. To this end, the present disclosure proposes the following examples.

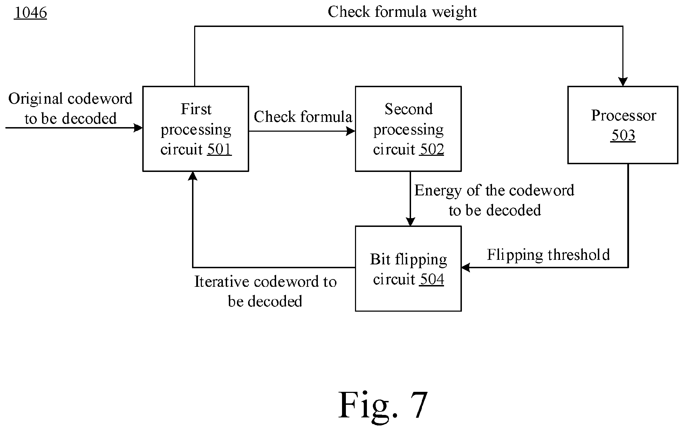

The present disclosure provides a decoder. FIG. 7 is a schematic diagram of the composition of the decoder provided by the examples of the present disclosure. As shown in FIG. 7, the decoder 1046 includes: a first processing circuit 501, a second processing circuit 502, a processor 503 and a bit flipping circuit 504, where the first processing circuit 501 is configured to: obtain a check formula and check formula weight based on a codeword to be decoded in a current iteration and a check matrix; the second processing circuit 502 is configured to: obtain energy of the codeword to be decoded in the current iteration based on the check formula, the check matrix and a flipping state of the codeword to be decoded in the current iteration; the processor 503 is configured to: in a first iteration, select one of a plurality of preset threshold sequences as an initial threshold sequence based on the check formula weight; and assign a flipping threshold in the initial threshold sequence to the bit flipping circuit; and the bit flipping circuit 504 is configured to: output a codeword to be decoded in a following iteration based on a result of a comparison between the energy of the codeword to be decoded in the current iteration and the flipping threshold assigned by the processor.

In an example of the present disclosure, the processor may be configured to select, one of the plurality of preset threshold sequences as the initial threshold sequence based on the check formula weight obtained by calculation using an original codeword to be decoded and the check matrix in the first iteration. The initial threshold sequence may include a plurality of flipping thresholds. The processor may assign a flipping threshold in the initial threshold sequence to the bit flipping circuit in each iteration, so that the bit flipping circuit determines whether to perform bit flipping on the codeword to be decoded based on the result of the comparison between the energy of the codeword to be decoded in the current iteration and the flipping threshold. That is, the processor may be configured to select the corresponding initial threshold sequence based on the degree of error of the original codeword to be decoded, rather than using the same flipping threshold or a threshold sequence composed of a plurality of flipping thresholds for any codeword to be decoded, thereby improving the flexibility of the decoder in performing decoding operations, reducing decoding time and improving decoding performance.

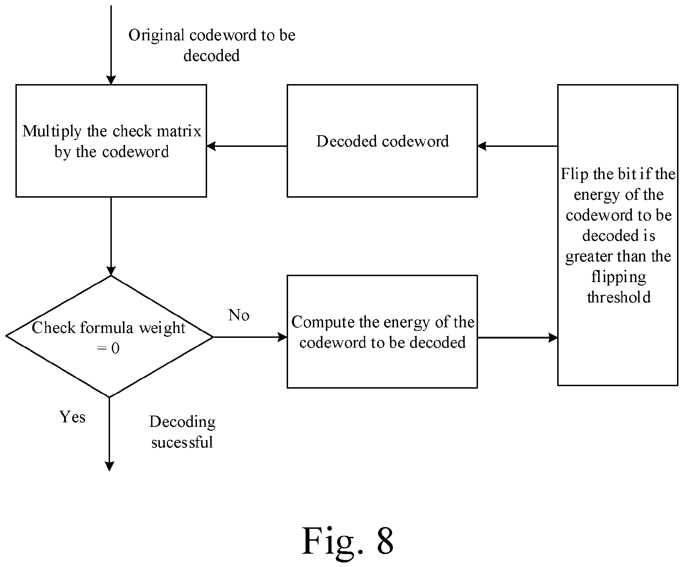

FIG. 8 is a flowchart of a decoding process provided by the example of the present disclosure. Referring to FIG. 8, the main process of decoding using the decoder in the example of the present disclosure includes: multiplying the check matrix with the original codeword to be decoded to obtain a check formula, where each bit in the check formula represents a result of a parity check of a check equation, 0 represents pass and 1 represents a check error. The check formula weight can be obtained by counting the number of bits being 1 in the check formula, where the original codeword to be decoded can be a vector. If each bit in the check formula is 0, the check formula weight is 0, indicating that the decoding is successful, and the decoder can output the original codeword to be decoded as the final decoded codeword. If any bit in the check formula is 1, the check formula weight is not 0 and iterations may be performed. In some examples, the original codeword to be decoded is used as the codeword to be decoded in the first iteration, the energy of the original codeword to be decoded, which could be understood as the energy of each bit in the original codeword to be decoded, is calculated in the first iteration and compared with the flipping threshold. If the energy of a bit in the original codeword to be decoded is greater than the flipping threshold, the bit is flipped. If the energy of a bit in the original codeword to be decoded is less than or equal to the flipping threshold, the bit is kept unchanged, thus obtaining the decoded codeword in the first iteration. The check matrix is multiplied by the decoded codeword in the first iteration to obtain the check formula and the check formula weight. If the check formula weight is 0, the decoding is successful, and the decoder can output the decoded codeword in the first iteration as the final decoded codeword. If the check formula weight is not 0, a second iteration is performed, and the codeword to be decoded in the second iteration is the decoded codeword in the first iteration. The process of each iteration is similar and will not be repeated. When the check formula weight is 0 in a certain iteration, the decoding is terminated, otherwise the iteration is performed for a next time.

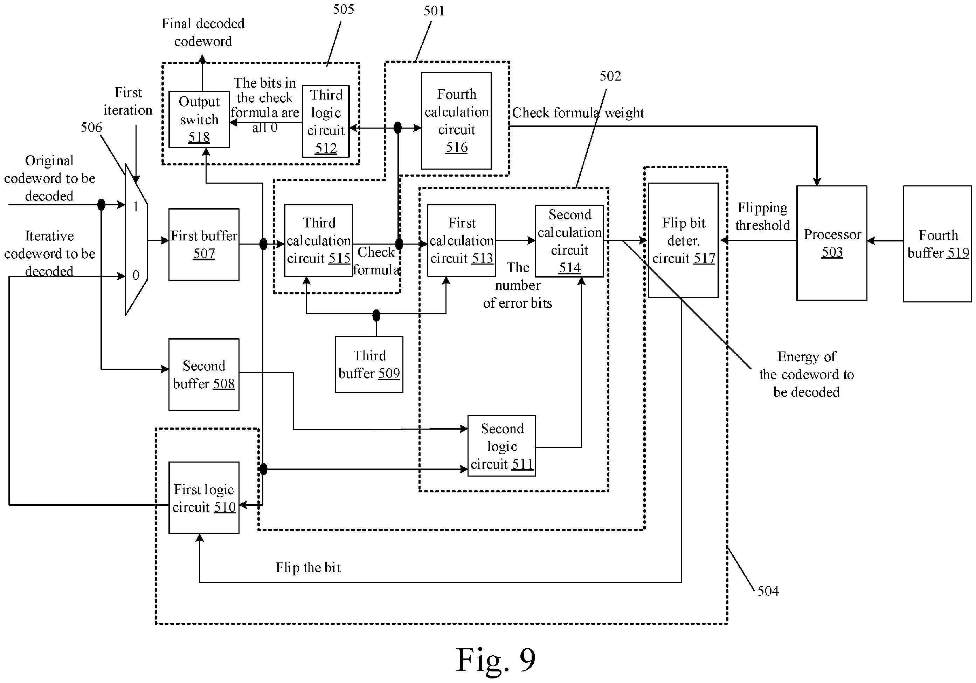

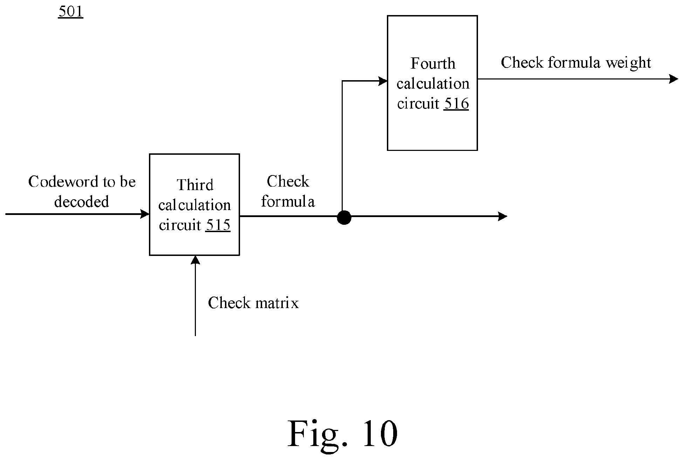

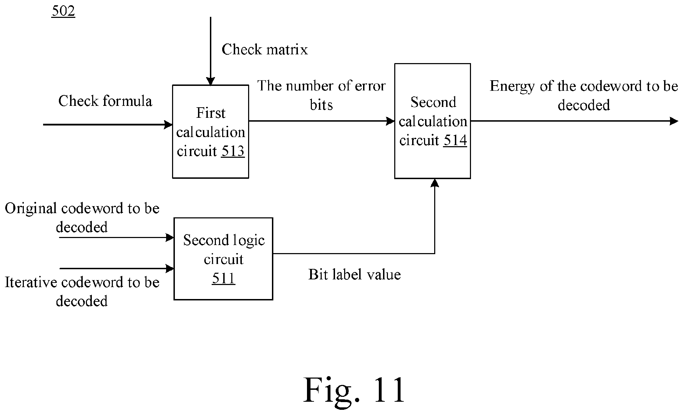

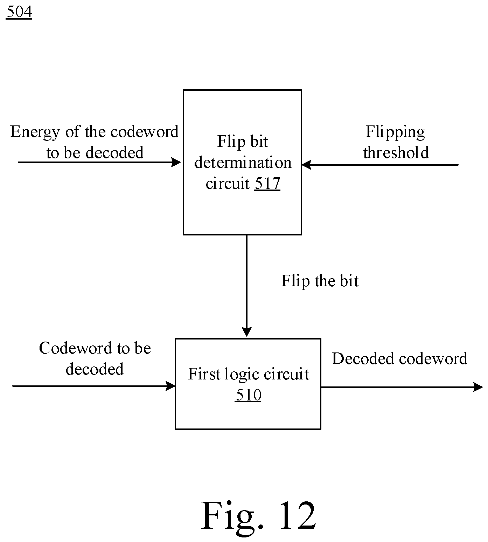

FIG. 9 is a structural schematic diagram of a decoder provided in an example of the present disclosure. FIG. 10 is a structural schematic diagram of a first processing circuit provided in an example of the present disclosure. FIG. 11 is a structural schematic diagram of a second processing circuit provided in an example of the present disclosure. FIG. 12 is a structural schematic diagram of a bit flipping circuit provided in an example of the present disclosure. The decoder and the decoding process of the decoder provided in the example of the present disclosure are described in detail below in conjunction with FIG. 9 to FIG. 12.

With reference to FIG. 9, the decoder 1046 further includes a first selector 506, a first buffer 507, and a second buffer 508. The first selector 506 can select one of the original codeword to be decoded and an iterative codeword to be decoded as an output based on whether the current iteration is the first iteration. If the current iteration is the first iteration, the first selector 506 selects the original codeword to be decoded as an output; and if the current iteration is not the first iteration, the first selector 506 selects the iterative codeword to be decoded as an output. The iterative codeword to be decoded here is the decoded codeword in the previous iteration. The codeword output from the first selector 506 can be cached in the first buffer 507, and the original codeword to be decoded can be cached in the second buffer 508.

In some examples, the first processing circuit 501 is configured to: perform a third calculation on the codeword to be decoded in the current iteration and the check matrix to obtain the check formula; and count the number of bits being 1 in the check formula to obtain the check formula weight.

With reference to FIG. 9 and FIG. 10, the first processing circuit 501 includes a third calculation circuit 515 and a fourth calculation circuit 516, where the third calculation circuit 515 is connected with the first buffer 507, and the fourth calculation circuit 516 is connected with the third calculation circuit 515. In some examples, the third calculation circuit 515 may include a matrix multiplier, and the fourth calculation circuit 516 may include an adder. The decoder further includes a third buffer 509, in which the check matrix is cached, and the third buffer 509 is connected with the third calculation circuit 515. The third calculation circuit 515 receives the codeword to be decoded in the current iteration in the first buffer 507 and the check matrix in the third buffer 509, and the third calculation circuit 515 multiplies the check matrix with the codeword to be decoded to obtain a check formula. In the example of the present disclosure, the check formula can be a vector, and each element of the vector can be obtained by performing corresponding multiplication and addition operations on an element in the codeword to be decoded and a part of the elements in the check matrix, where the addition operation is modulo 2 addition (1+1=0). The fourth calculation circuit 516 is configured to count the number of bits being 1 in the check formula, thereby obtaining the check formula weight.

In some examples, referring to FIG. 9, the decoder further includes: an output circuit 505 configured to: output the codeword to be decoded in the current iteration as a final decoded codeword according to bits in the check formula in the current iteration all being 0.

In some examples, referring to FIG. 9, the output circuit 505 includes a third logic circuit 512 and an output switch 518. The third logic circuit 512 is connected with the third calculation circuit 515, and the output switch 518 is connected with both the third logic circuit 512 and the first buffer 507. In some examples, the third logic circuit 512 can be an OR gate, and can be configured to determine whether each bit in the check formula is 0. The output switch 518 can be in a closed state based on each bit in the check formula all being 0, so that the codeword to be decoded in the current iteration cached in the first buffer 507 is output as the final codeword. The output switch 518 can also be in an open state based on any bit in the check formula being 1. It should be noted that the third logic circuit 512 can also include a combination of other logic gates that implement the same function.

In some examples, the second processing circuit 502 is configured to: perform a first calculation on the check formula and the check matrix to obtain the number of errors corresponding to each bit in the codeword to be decoded in the current iteration; according to a flipping state of each bit in the codeword to be decoded in the current iteration, obtain a label value corresponding to each bit; and perform a second calculation on the number of errors and the label value corresponding to each bit in the codeword to be decoded in the current iteration to obtain the energy of the codeword to be decoded in the current iteration.

Referring to FIG. 9 and FIG. 11, in some examples, the second processing circuit 502 may include a first calculation circuit 513, a second calculation circuit 514, and a second logic circuit 511, where the first calculation circuit 513 may be connected with both the third calculation circuit 515 and the third buffer 509, and the second logic circuit 511 may be connected with both the first buffer 507 and the second buffer 508. In some examples, the first calculation circuit 513 can be a matrix multiplier to multiply the check matrix with the check formula to obtain the number of error bits. The number of error bits here can be a vector, and each element in the vector is the number of errors corresponding to a bit in the codeword to be decoded in the current iteration. The second logic circuit 511 can be an XOR gate, and can determine whether each bit in the codeword to be decoded in the current iteration is flipped based on the codeword to be decoded in the current iteration cached in the first buffer 507 and the original codeword to be decoded cached in the second buffer 508. For example, if a bit in the codeword to be decoded in the current iteration is the same as the bit in the original codeword to be decoded, the bit is not flipped, and the label value of the bit is 0; and if a bit in the codeword to be decoded in the current iteration is different from the bit in the original codeword to be decoded, the bit is flipped, and the label value of the bit is 1. It should be noted that the second logic circuit 511 can also include a combination of other logic gates that implement the same function.

In some examples, the bit flipping circuit 504 is configured to: compare energy of each bit in the codeword to be decoded in the current iteration with the flipping threshold in the current iteration; flip a bit according to the energy of the bit being greater than the flipping threshold in the current iteration, or keep a bit unchanged according to the energy of the bit being less than or equal to the flipping threshold in the current iteration, to obtain a decoded codeword in the current iteration; and output the decoded codeword in the current iteration as the codeword to be decoded in the following iteration.

Referring to FIG. 9 and FIG. 12, the bit flipping circuit 504 includes a flip bit determination circuit 517 and a first logic circuit 510, where the flip bit determination circuit 517 is connected with the second calculation circuit 514, the processor 503 and the first logic circuit 510, and the first logic circuit 510 is connected with the first buffer 507 and the first selector 506. The flip bit determination circuit 517 can be configured to compare the energy of each bit in the codeword to be decoded in the current iteration with the flipping threshold in the current iteration. In some examples, if the energy of a bit in the codeword to be decoded in the current iteration is greater than the flipping threshold, a flip label value of the bit is 1; and if the energy of a bit in the codeword to be decoded in the current iteration is less than or equal to the flipping threshold, the flip label value of the bit is 0. The first logic circuit 510 can be an XOR gate which performs an XOR operation on each bit of the codeword to be decoded in the current iteration and the flip label value of the corresponding bit, thereby obtaining the decoded codeword in the current iteration. In some other examples, if the energy of a bit in the codeword to be decoded in the current iteration is greater than the flipping threshold, the flip label value of the bit is 0; and if the energy of a bit in the codeword to be decoded in the current iteration is less than or equal to the flipping threshold, the flip label value of the bit is 1. The first logic circuit 510 can be an XNOR gate which performs an XNOR operation on each bit in the codeword to be decoded in the current iteration and the flip label value of the corresponding bit, thereby obtaining the decoded codeword in the current iteration, that is, the iterative codeword to be decoded in FIG. 9. It should be noted that the first logic circuit 510 can also include a combination of other logic gates that implement the same function.

In the example of present disclosure, the flipping threshold in each iteration can be assigned to the bit flipping circuit 504 by the processor 503. Here, the processor 503 can be a control unit in the memory controller, or a hardware processor independent of the control unit of the memory system.

In some examples, the processor 503 is configured to: in the first iteration, obtain N+1 preset threshold sequences, compare the check formula weight with N first thresholds, and select one of the N+1 preset threshold sequences as the initial threshold sequence according to a result of the comparison, where N is a positive integer. Here, the check formula weight in the first iteration is the initial check formula weight of the codeword to be decoded in the read data.

In some examples, N may be 1, and the processor 503 is configured to: in the first iteration, compare the check formula weight with one of the first thresholds; and according to the check formula weight being greater than the first threshold, select a preset threshold sequence corresponding to the check formula weight being greater than the first threshold as the initial threshold sequence, or, according to the check formula weight being less than or equal to the first threshold, select a preset threshold sequence corresponding to the check formula weight being less than or equal to the first threshold as the initial threshold sequence.

In some examples, N may be greater than 1, and the processor 503 is configured to: in the first iteration, compare the check formula weight with a plurality of the first thresholds to determine a threshold interval in which the check formula weight is located; and select a preset threshold sequence corresponding to the threshold interval in which the check weight is located as the initial threshold sequence. Here, the plurality of first threshold values may be different from each other.

In some examples, the initial threshold sequence includes M flipping thresholds, M is an integer greater than 1, and the processor 503 is configured to: in a Lth iteration, assign a Lth flipping threshold in the initial threshold sequence to the bit flipping circuit 504, where L is a positive integer less than or equal to M.

In some examples, the processor 503 may sequentially assign the M flipping thresholds in the initial threshold sequence to the bit flipping circuit 504 in a certain order. For example, the processor 503 may sequentially assign the M flipping thresholds in the initial threshold sequence to the bit flipping circuit 504 in the order in which the flipping thresholds are arranged in the initial threshold sequence, but the present disclosure is not limited thereto.

In the example of the present disclosure, the processor 503 may obtain a plurality of preset threshold sequences which are preset, select one of the plurality of preset threshold sequences as the initial threshold sequence based on the relationship between the initial check formula weight and the first threshold, and in each iteration, assign a flipping threshold in the initial threshold sequence to the bit flipping circuit, so that the bit flipping circuit determines whether to perform bit flipping on the codeword to be decoded in the current iteration based on the relationship between the flipping threshold and the check formula weight. On the one hand, selecting the initial threshold sequence based on the initial check formula weight can provide different flipping thresholds for codewords to be decoded with different degrees of error, which can improve the flexibility and pertinence of the selection of the flipping threshold, thereby improving the decoding performance of the decoder. On the other hand, the initial threshold sequence includes a plurality of flipping thresholds, which can avoid the prolongation of the decoding time caused by the need to determine the corresponding flipping threshold by a complex algorithm in each iteration, and thus can improve the decoding efficiency of the decoder.

In some examples, when each of the M flipping thresholds in the initial threshold sequence has been assigned to the bit flipping circuit, and the bits in the check formula obtained based on the iterative codeword to be decoded and the check matrix are still not all 0, it means that the decoding process still needs to continue, and the processor 503 is further configured to: in an M+Xth iteration, obtain a cyclic threshold sequence, and assign a flipping threshold in the cyclic threshold sequence to the bit flipping circuit, where X is a positive integer.

In some examples, the processor 503 is further configured to: obtain P+1 preset cyclic sequences, compare the check formula weight in the first iteration or the check formula weight in the M+1th iteration with P second thresholds, and select one of the P+1 preset cyclic sequences as the cyclic threshold sequence according to a result of the comparison, where P is a positive integer.

In some examples, referring to FIG. 9, the decoder 1046 may further include a fourth buffer 519 configured to store the preset threshold sequences and the preset cyclic sequences, and the processor 503 may be configured to obtain the preset threshold sequences and the preset cyclic sequences from the fourth buffer 519.

In some examples, with reference to FIG. 6 and FIG. 9, for the decoder 1046 in the memory system 102, the preset threshold sequences and the preset cyclic sequences can be configured to be stored in the memory device 103. When the memory system 102 is powered on, the plurality of preset threshold sequences stored in the memory device 103 can be read out and cached in the fourth buffer 519.

In the example of the present disclosure, after the flipping thresholds in the initial threshold sequence have been used up, the processor 503 can also use one of the plurality of preset cyclic sequences as the cyclic threshold sequence. In each of the following iterations, the processor 503 can assign a flipping threshold in the cyclic threshold sequence to the bit flipping circuit 504, and the plurality of flipping thresholds in the cyclic threshold sequence can be used in a cyclic manner, thereby saving the cache space for storing the preset threshold sequences and the preset cyclic sequences. In addition, the processor 503 can select a corresponding preset cyclic sequence as the cyclic threshold sequence based on the threshold interval in which the initial check formula weight or the check formula weight after the initial threshold sequence is used up is located, and can further assign different flipping thresholds to the codewords to be decoded with different degrees of error, thereby further improving the decoding performance.

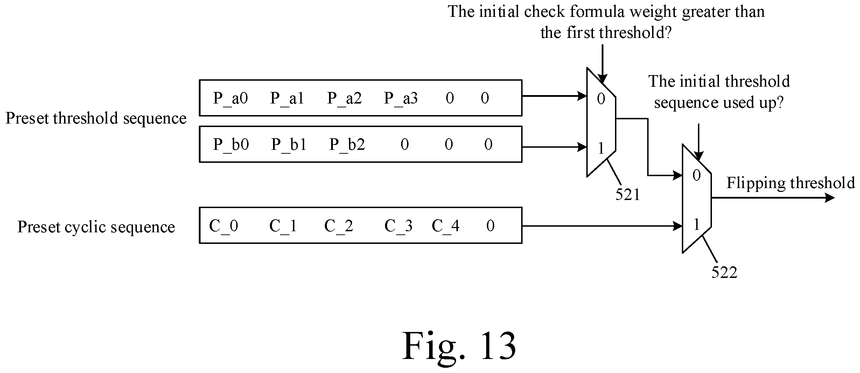

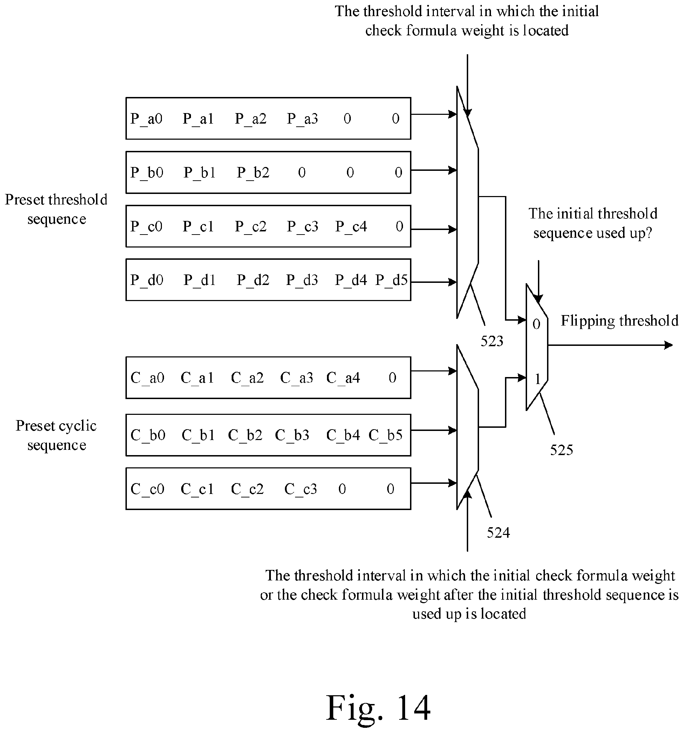

FIG. 13 and FIG. 14 are circuit structural schematic diagrams of a part of the processor 503 provided by two examples of the present disclosure, respectively. The following will introduce the process of assigning the flipping threshold of the processor 503 in conjunction with the examples.

In an example, as shown in FIG. 13, the processor 503 may include a second selector 521 and a third selector 522. The input end of the second selector 521 may receive two preset threshold sequences, where one of the two preset threshold sequences may correspond to the check formula weight being greater than the first threshold, and the other preset threshold sequence may correspond to the check formula weight being less than or equal to the first threshold. The control end of the second selector 521 may receive the result of the comparison of the initial check formula weight and the first threshold. The second selector 521 may be configured to: according to the check formula weight being greater than the first threshold, output a preset threshold sequence corresponding to the check formula weight being greater than the first threshold, or according to the check formula weight being less than or equal to the first threshold, output a preset threshold sequence corresponding to the check formula weight being less than or equal to the first threshold. The input end of the third selector 522 can receive a cyclic threshold sequence and can be configured to: when the initial threshold sequence is not used up, output the flipping thresholds in the initial threshold sequence; and after the initial threshold sequence is used up, output the flipping thresholds in the cyclic threshold sequence.

In some examples, as shown in FIG. 14, the processor 503 may include a fourth selector 523, a fifth selector 524, and a sixth selector 525, where the input end of the fourth selector 523 can receive four preset threshold sequences. The processor 503 can be configured to: in the first iteration, compare the check formula weight with three first thresholds to determine the threshold interval in which the initial check formula weight is located. The fourth selector 523 can be configured to: according to the threshold interval in which the initial check formula weight is located, output the preset threshold sequence corresponding to the threshold interval in the four preset threshold sequences as the initial threshold sequence. The input end of the fifth selector 524 can receive three preset cyclic sequences, and the processor 503 can be configured to: in an M+1th iteration, compare the initial check formula weight or the check formula weight in the current iteration with two second thresholds to determine the threshold interval in which the initial check formula weight or the check formula weight in the current iteration is located, where M is the number of flipping thresholds in the initial threshold sequence. The fifth selector 524 can be configured to: according to the threshold interval in which the initial check formula weight is located or the threshold interval in which the check formula weight in the current iteration is located, output the preset cyclic sequence corresponding to the threshold interval in the three preset cyclic sequences as the cyclic threshold sequence. The sixth selector 525 can be configured to: when the initial threshold sequence is not used up, output the flipping thresholds in the initial threshold sequence; and after the initial threshold sequence is used up, output the flipping thresholds in the cyclic threshold sequence.

It should be noted that in the above examples, the preset threshold sequence, the number of preset cyclic sequences, and the number of flipping thresholds in each sequence are only examples, and the present disclosure does not make specific restrictions on this, and the present disclosure does not make specific restrictions on the magnitude of each flipping threshold.

In an example of the present disclosure, when the number of preset threshold sequences is N+1 and the number of preset cyclic sequences is P+1, the processor 503 may be configured to assign a flipping threshold in one of (N+1)*(P+1) combinations of the threshold sequences to the bit flipping circuit when performing a decoding operation on the codeword to be decoded, thereby improving the flexibility of the flipping threshold assignment and improving the decoding efficiency and decoding performance of the decoder.

Based on the above decoder, the example of the present disclosure further provides a controller, including: an interface configured to: receive read data; a decoder as described in any of the above examples, configured to: decode a codeword to be decoded in the read data.

The controller here may be the memory controller 104 as shown in FIG. 1 and FIG. 6. The interface here may be the memory interface 1042 as shown in FIG. 6.

Based on the above decoder, the example of the present disclosure further provides a memory system, including: a memory configured to: output read data; a decoder as described in any of the above examples, configured to: decode a codeword to be decoded in the read data.

In some examples, the memory system further includes: an encoder configured to: receive write data and encode the write data, where the memory is further configured to: receive encoded write data.

In some examples, the memory system includes a controller coupled to the memory, where the controller includes the decoder and the encoder.

The structure and composition of the memory system here can refer to the detailed description of FIG. 1 to FIG. 6, and will not be repeated for the sake of brevity. The memory here can be the memory device 103 as shown in FIG. 1 to FIG. 6. The controller here can be the memory controller 104 as shown in FIG. 1 and FIG. 6.

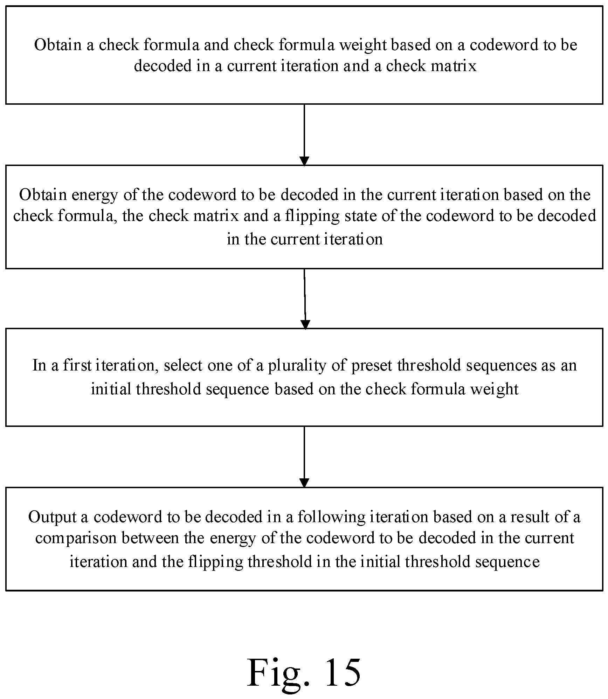

Based on the above decoder, the example of the present disclosure also provides a decoding method. FIG. 15 is a flow chart of the decoding method provided by the example of the present disclosure. As shown in FIG. 15, the decoding method includes: obtaining a check formula and check formula weight based on a codeword to be decoded in a current iteration and a check matrix; obtaining energy of the codeword to be decoded in the current iteration based on the check formula, the check matrix and a flipping state of the codeword to be decoded in the current iteration; in a first iteration, selecting one of a plurality of preset threshold sequences as an initial threshold sequence based on the check formula weight; and outputting a codeword to be decoded in a following iteration based on a result of a comparison between the energy of the codeword to be decoded in the current iteration and a flipping threshold in the initial threshold sequence.

In some examples, in a first iteration, selecting one of a plurality of preset threshold sequences as an initial threshold sequence based on the check formula weight, and outputting a codeword to be decoded in a following iteration based on a result of a comparison between the energy of the codeword to be decoded in the current iteration and a flipping threshold in the initial threshold sequence includes: in the first iteration, obtaining N+1 preset threshold sequences, comparing the check formula weight with N first thresholds, and selecting one of the N+1 preset threshold sequences as the initial threshold sequence according to a result of the comparison, where the initial threshold sequence includes M flipping thresholds, N is a positive integer, and M is an integer greater than 1; and in a Lth iteration, outputting the codeword to be decoded in the following iteration based on a result of a comparison between the energy of the codeword to be decoded in the current iteration and a Lth flipping threshold in the initial threshold sequence, where L is a positive integer less than or equal to M.

In some examples, N is 1, and in the first iteration, comparing the check formula weight with N first thresholds, and selecting one of the N+1 preset threshold sequences as the initial threshold sequence according to a result of the comparison includes: in the first iteration, comparing the check formula weight with one of the first thresholds; and according to the check formula weight being greater than the first threshold, selecting a preset threshold sequence corresponding to the check formula weight being greater than the first threshold as the initial threshold sequence, or, according to the check formula weight being less than or equal to the first threshold, selecting a preset threshold sequence corresponding to the check formula weight being less than or equal to the first threshold as the initial threshold sequence.

In some examples, N is 1, and in the first iteration, comparing the check formula weight with N first thresholds, and selecting one of the N+1 preset threshold sequences as the initial threshold sequence according to a result of the comparison includes: in the first iteration, comparing the check formula weight with a plurality of the first thresholds to determine a threshold interval in which the check formula weight is located; and selecting a preset threshold sequence corresponding to the threshold interval in which the check weight is located as the initial threshold sequence.

In some examples, the decoding method further includes: in an M+Xth iteration, obtaining a cyclic threshold sequence, and outputting the codeword to be decoded in the following iteration based on a result of a comparison between the energy of the codeword to be decoded in the current iteration and a flipping threshold in the cyclic threshold sequence, where X is a positive integer.

In some examples, the decoding method further includes: in an M+1th iteration, obtaining P+1 preset cyclic sequences, comparing the check formula weight in the first iteration or the check formula weight in the M+1th iteration with P second thresholds, and selecting one of the P+1 preset cyclic sequences as the cyclic threshold sequence according to a result of the comparison, where P is a positive integer.

In some examples, obtaining energy of the codeword to be decoded in the current iteration based on the check formula, the check matrix and a flipping state of the codeword to be decoded in the current iteration includes: performing a first calculation on the check formula and the check matrix to obtain the number of errors corresponding to each bit in the codeword to be decoded in the current iteration; according to a flipping state of each bit in the codeword to be decoded in the current iteration, obtaining a label value corresponding to each bit; and performing a second calculation on the number of errors and the label value corresponding to each bit in the codeword to be decoded in the current iteration to obtain the energy of the codeword to be decoded.

In some examples, outputting a codeword to be decoded in a following iteration based on a result of a comparison between the energy of the codeword to be decoded in the current iteration and a flipping threshold in the initial threshold sequence includes: comparing energy of each bit in the codeword to be decoded in the current iteration with the flipping threshold; flipping a bit according to the energy of the bit being greater than the flipping threshold, or keeping a bit unchanged according to the energy of the bit being less than or equal to the flipping threshold, to obtain a decoded codeword in the current iteration; and outputting the decoded codeword in the current iteration as the codeword to be decoded in the following iteration.

In some examples, obtaining a check formula and check formula weight based on a codeword to be decoded in a current iteration and a check matrix includes: performing a third calculation on the codeword to be decoded in the current iteration and the check matrix to obtain the check formula; and counting the number of bits being 1 in the check formula to obtain the check formula weight.

In some examples, the decoding method further includes outputting the codeword to be decoded in the current iteration as a final decoded codeword according to bits in the check formula in the current iteration all being 0.

Based on the above decoding method, the example of the present disclosure further provides a computer-readable storage medium, having stored thereon a computer program that, when executed by a processor, performs the decoding method described in any of the above examples.

Here, all or part of the processes in the decoding method in the above examples can be implemented by instructing related hardware through a computer program, and the program can be stored in a computer-readable storage medium. When the program is executed, the processes of the examples of the above methods can be implemented. In some examples, the computer-readable storage medium 601 may include a magnetic random access memory (FRAM), a read-only memory (ROM), a programmable read-only memory (PROM), an erasable programmable read-only memory (EPROM), an electrically erasable programmable read-only memory (EEPROM), a flash memory, a magnetic surface memory, an optical disk, or a compact disc read-only memory (CD-ROM) or other memory; or it may include various devices including one or any combination of the above memory devices.

The features disclosed in the several device examples provided in the present disclosure may be arbitrarily combined to obtain a new device example without conflict.

The methods disclosed in the several method examples provided in the present disclosure may be arbitrarily combined to obtain a new method example without conflict.

The above description provide some examples of the present disclosure, but the protection scope of the present disclosure is not limited thereto. Any person skilled in the art can easily think of changes or substitutions within the technical scope disclosed in the present disclosure, which should be included in the protection scope of the present disclosure.

## Claims

1. A decoder (1046), comprising:
a first processing circuit (501) configured to:
obtain a check formula and check formula weight based on a codeword to be decoded in a current iteration and a check matrix;
a second processing circuit (502) configured to:
obtain energy of the codeword to be decoded in the current iteration based on the check formula, the check matrix and a flipping state of the codeword to be decoded in the current iteration;
a processor (503) configured to:
in a first iteration, select one of a plurality of preset threshold sequences as an initial threshold sequence based on the check formula weight; and
assign a flipping threshold in the initial threshold sequence to a bit flipping circuit (504); and
the bit flipping circuit (504) configured to:
output the codeword to be decoded in a following iteration based on a result of a comparison between the energy of the codeword to be decoded in the current iteration and the flipping threshold assigned by the processor (503).

2. The decoder (1046) of claim 1, wherein the processor (503) is configured to:
in the first iteration, obtain N+1 preset threshold sequences, compare the check formula weight with N first thresholds, and select one of the N+1 preset threshold sequences as the initial threshold sequence according to a result of the comparison, wherein the initial threshold sequence comprises M flipping thresholds, N is a positive integer, and M is an integer greater than 1; and
in a Lth iteration, assign a Lth flipping threshold in the initial threshold sequence to the bit flipping circuit (504), wherein L is a positive integer less than or equal to M.

3. The decoder (1046) of claim 2, wherein N is 1, and the processor (503) is configured to:
in the first iteration, compare the check formula weight with one of the first thresholds; and according to the check formula weight being greater than the first threshold, select a preset threshold sequence corresponding to the check formula weight being greater than the first threshold as the initial threshold sequence, or, according to the check formula weight being less than or equal to the first threshold, select a preset threshold sequence corresponding to the check formula weight being less than or equal to the first threshold as the initial threshold sequence.

4. The decoder (1046) of claim 2, wherein N is greater than 1, and the processor (503) is configured to:
in the first iteration, compare the check formula weight with a plurality of the first thresholds to determine a threshold interval in which the check formula weight is located; and
select a preset threshold sequence corresponding to the threshold interval in which the check formula weight is located as the initial threshold sequence.

5. The decoder (1046) of claim 2, wherein the processor (503) is further configured to:
in an M+Xth iteration, obtain a cyclic threshold sequence, and assign a flipping threshold in the cyclic threshold sequence to the bit flipping circuit (504), wherein X is a positive integer.

6. The decoder (1046) of claim 5, wherein the processor (503) is further configured to:
in an M+1th iteration, obtain P+1 preset cyclic sequences, compare the check formula weight in the first iteration or the check formula weight in the M+1th iteration with P second thresholds, and select one of the P+1 preset cyclic sequences as the cyclic threshold sequence according to a result of the comparison, wherein P is a positive integer.

7. The decoder (1046) of claim 1, wherein the second processing circuit (502) is configured to:
perform a first calculation on the check formula and the check matrix to obtain a number of errors corresponding to each bit in the codeword to be decoded in the current iteration;
according to a flipping state of each bit in the codeword to be decoded in the current iteration, obtain a label value corresponding to each bit; and
perform a second calculation on the number of errors and the label value corresponding to each bit in the codeword to be decoded in the current iteration, to obtain the energy of the codeword to be decoded, and preferably
wherein the bit flipping circuit (504) is configured to:
compare energy of each bit in the codeword to be decoded in the current iteration with the flipping threshold;
flip a bit according to the energy of the bit being greater than the flipping threshold, or keep a bit unchanged according to the energy of the bit being less than or equal to the flipping threshold, to obtain a decoded codeword in the current iteration; and
output the decoded codeword in the current iteration as the codeword to be decoded in the following iteration.

8. The decoder (1046) of claim 1, wherein the first processing circuit (501) is configured to:
perform a third calculation on the codeword to be decoded in the current iteration and the check matrix, to obtain the check formula; and
count a number of bits being 1 in the check formula to obtain the check formula weight.

9. The decoder (1046) of claim 1, further comprising:
an output circuit configured to:
output the codeword to be decoded in the current iteration as a final decoded codeword according to bits in the check formula in the current iteration all being 0.

10. A method of decoding, comprising:
obtaining a check formula and check formula weight based on a codeword to be decoded in a current iteration and a check matrix;
obtaining energy of the codeword to be decoded in the current iteration based on the check formula, the check matrix and a flipping state of the codeword to be decoded in the current iteration;
in a first iteration, selecting one of a plurality of preset threshold sequences as an initial threshold sequence based on the check formula weight; and
outputting a codeword to be decoded in a following iteration based on a result of a comparison between the energy of the codeword to be decoded in the current iteration and a flipping threshold in the initial threshold sequence.

11. The method of claim 10, wherein in a first iteration, selecting one of a plurality of preset threshold sequences as an initial threshold sequence based on the check formula weight, and outputting a codeword to be decoded in a following iteration based on a result of a comparison between the energy of the codeword to be decoded in the current iteration and a flipping threshold in the initial threshold sequence comprises:
in the first iteration, obtaining N+1 preset threshold sequences, comparing the check formula weight with N first thresholds, and selecting one of the N+1 preset threshold sequences as the initial threshold sequence according to a result of the comparison, wherein the initial threshold sequence comprises M flipping thresholds, N is a positive integer, and M is an integer greater than 1; and
in a Lth iteration, outputting the codeword to be decoded in the following iteration based on a result of a comparison between the energy of the codeword to be decoded in the current iteration and a Lth flipping threshold in the initial threshold sequence, wherein L is a positive integer less than or equal to M.

12. The method of claim 11, wherein N is 1, and in the first iteration, comparing the check formula weight with N first thresholds, and selecting one of the N+1 preset threshold sequences as the initial threshold sequence according to a result of the comparison comprises:
i) in the first iteration, comparing the check formula weight with one of the first thresholds; and according to the check formula weight being greater than the first threshold, selecting a preset threshold sequence corresponding to the check formula weight being greater than the first threshold as the initial threshold sequence, or, according to the check formula weight being less than or equal to the first threshold, selecting a preset threshold sequence corresponding to the check formula weight being less than or equal to the first threshold as the initial threshold sequence;
and/or
ii) in the first iteration, comparing the check formula weight with a plurality of the first thresholds to determine a threshold interval in which the check formula weight is located; and selecting a preset threshold sequence corresponding to the threshold interval in which the check formula weight is located as the initial threshold sequence.

13. The method of claim 10,
a) wherein obtaining energy of the codeword to be decoded in the current iteration based on the check formula, the check matrix and a flipping state of the codeword to be decoded in the current iteration comprises:
performing a first calculation on the check formula and the check matrix to obtain a number of errors corresponding to each bit in the codeword to be decoded in the current iteration;
according to a flipping state of each bit in the codeword to be decoded in the current iteration, obtaining a label value corresponding to each bit; and
performing a second calculation on the number of errors and the label value corresponding to each bit in the codeword to be decoded in the current iteration, to obtain the energy of the codeword to be decoded;
and/or
b) wherein obtaining a check formula and check formula weight based on a codeword to be decoded in a current iteration and a check matrix comprises:
performing a third calculation on the codeword to be decoded in the current iteration and the check matrix to obtain the check formula; and
counting a number of bits being 1 in the check formula to obtain the check formula weight;
and/or
c) further comprising:
outputting the codeword to be decoded in the current iteration as a final decoded codeword according to bits in the check formula in the current iteration all being 0.

14. A memory system (102), comprising:
a memory configured to output read data; and
a decoder (1046) configured to decode a codeword to be decoded in the read data, wherein the decoder (1046) comprises:
a first processing circuit (501) configured to:
obtain a check formula and check formula weight based on a codeword to be decoded in a current iteration and a check matrix;
a second processing circuit (502) configured to:
obtain energy of the codeword to be decoded in the current iteration based on the check formula, the check matrix and a flipping state of the codeword to be decoded in the current iteration;
a processor (503) configured to:
in a first iteration, select one of a plurality of preset threshold sequences as an initial threshold sequence based on the check formula weight; and
assign a flipping threshold in the initial threshold sequence to a bit flipping circuit (504); and
the bit flipping circuit (504) configured to:
output a codeword to be decoded in a following iteration based on a result of a comparison between the energy of the codeword to be decoded in the current iteration and the flipping threshold assigned by the processor (503).

15. The memory system (102) of claim 14, further comprising:
an encoder (1045) configured to receive write data and encode the write data, and
wherein the memory is further configured to receive encoded write data, and wherein the memory system (102) preferably comprises:
a controller (104) coupled with the memory, wherein the controller (104) comprises the decoder (1046) and the encoder (1045).
